Europäisches Patentamt

European Patent Office

Office européen des brevets

(19)

(11) Veröffentlichungsnummer: **0 168 895**
**B1**

(12) **EUROPÄISCHE PATENTSCHRIFT**

(45) Veröffentlichungstag der Patentschrift:
11.10.89

(21) Anmeldenummer: 85201160.0

(22) Anmeldetag: 10.07.85

(51) Int. Cl.⁴: **H 04 R 25/00**, H 03 G 1/02

(54) Hörgerät.

(30) Priorität: 18.07.84 AT 2329/84

(43) Veröffentlichungstag der Anmeldung:
22.01.86 Patentblatt 86/04

(45) Bekanntmachung des Hinweises auf die Patenterteilung: 11.10.89 Patentblatt 89/41

(84) Benannte Vertragsstaaten:
CH DE FR GB IT LI

(56) Entgegenhaltungen:
DE-A- 1 938 381
DE-A- 2 239 221
DE-A- 2 407 726
DE-A- 2 423 716
DE-A- 2 618 381
DE-A- 2 846 492
DE-A- 3 205 685
DE-A- 3 205 686
GRUNDIG TECHNISCHE INFORMATIONEN, Band 26, Nr. 4, 1979, Seiten 163-173, Furth, DE; E. DAZIAN: "Vollelektronisch, fernbedienbar, mit Sendersuchlauf; HiFi-PreCeiver X6500 TP; HiFi-Studio XPC6500 TP"

(73) Patentinhaber: Viennatone Gesellschaft m.b.H.
Fröbelgasse 28-30
A-1164 Wien (AT)

(72) Erfinder: Hueber, Fritz
Messerschmidtgasse 46A
A-1180 Wien (AT)

(74) Vertreter: Kliment, Peter, Dipl.-Ing. Mag.-jur.
Singerstrasse 8
A-1010 Wien (AT)

**Beschreibung**

Die Erfindung bezieht sich auf ein Hörgerät mit einer Fernsteuereinrichtung zur Lautstärkesteuerung, wobei das Hörgerät ein Mikrofon, eine Verstärkerschaltung, eine Lautstärkesteuerschaltung und einen Hörer aufweist und die Fernsteuereinrichtung einen vom Hörgerät räumlich getrennten und diesem individuell zugeordneten Sender aufweist, der die Lautstärkesteuerschaltung beeinflussende Steuersignale wahlweise abstrahlt und im Hörgerät eine Empfangseinrichtung für diese Steuersignale vorgesehen ist, der die Lautstärkesteuerschaltung nachgeschaltet ist.

In den letzten Jahren sind derartige am Kopf getragene Hörgeräte für Schwerhörige immer kleiner geworden. Die Fortschritte in der Bauteil-Technologie haben dazu geführt, daß nicht nur die bekannten Hinter-Ohr-Geräte entsprechend verkleinert werden konnten. Hörgeräte können heute so klein gebaut werden, daß sie sogar als Im-Ohr- oder Ohrkanal-Geräte getragen werden können.

Hand in Hand mit der Miniaturisierung der Geräte mußte auch eine Miniaturisierung der Bedienungselemente, wie Schalter und Lautstärkesteller stattfinden. Dies hat dazu geführt, daß insbesondere die Rädchen zur Einstellung der üblichen Lautstärke-Potentiometer heute oft schon so klein sind, daß sie von den meist älteren Schwerhörigen mit altersbedingt verminderter Feinmotorik der Finger nicht mehr eingestellt werden können.

Ein Hörgerät der eingangs erwähnten Art wurde z. B. durch die DE-A-19 38 381 bekannt. Bei diesem bekannten Gerät erfolgt die Aufnahme des Steuersignales, das auf einen HF-Träger aufmoduliert ist, nicht über das Mikrofon des Hörgerätes, sondern durch einen aus Spule und Kondensator bestehenden HF-Schwingkreis, der sein Signal aus der im Sender eingebauten Spule erhält. Die Steuerung der Lautstärke im Hörgerät erfolgt rein analog mittels Transistoren, die mit einer trägerabhängigen Regelspannung aus dem Schwingkreis versorgt werden. Da die Lautstärkeinformation nicht gespeichert wird, muß der Sender während des Betriebes ständig eingeschaltet bleiben. Dieses bekannte Gerät benötigt daher einen eigenen Empfangswandler für die Steuersignale und der Sender hat einen für die tägliche Praxis nicht vertretbaren hohen Stromverbrauch. Da die Feldstärke des Steuersignales nicht nur von der Senderleistung, sondern auch vom Abstand des Senders vom Hörgerät abhängt, bewirkt auch eine Abstandsänderung eine Lautstärkeänderung.

Ziel der Erfindung ist es daher ein Hörgerät der eingangs erwähnten Art vorzuschlagen, das sich durch einen einfachen Aufbau und Bedienung der Lautstärkeregelung auszeichnet. Außerdem soll ein nur geringer Stromverbrauch für die Lautstärkeregelung sicher gestellt sein.

Erfindungsgemäß wird dies dadurch erreicht, daß der Sender zur Abstrahlung von im Übertragungsbereich des Mikrofons des Hörgerätes und außerhalb des Übertragungsbereiches dessen Hörers liegenden Steuersignale vorgesehen ist und das Mikrofon gleichzeitig die Empfangseinrichtung für die Steuersignale bildet, wobei dem Mikrofon eine durch ein Hoch- und eine Tiefpaßfilter gebildete frequenzselektive Schaltung zur Trennung der Nutz- von der Steuersignalen nachgeschaltet ist und die der frequenzselektiven Schaltung nachgeschaltete Lautstärkesteuerschaltung einen Speicher zur Speicherung der der eingestellten Lautstärke entsprechenden Signale aufweist.

Da der Sender eine Trägerfrequenz abstrahlt, die außerhalb des Übertragungsbereiches des Hörers des Hörgerätes, vorzugsweise über diesem, liegt, wird eine Beeinträchtigung der Verständlichkeit während einer Änderung z. B. der Lautstärkeeinstellung vermieden. Auf diese Weise sind die zur Veränderung z. B. der Lautstärkeeinstellung nötigen Steuersignale im Hörer des eigentlichen Hörgerätes nicht vernehmbar, wobei sich bei der Wahl von über dem Hörbereich liegenden Steuersignalen der Vorteil einer guten Trennschärfe bei geringem schaltungstechnischen Aufwand ergibt.

Durch diese Maßnahmen ist es möglich auf gesonderte Empfangsschaltungen für die Steuersignale, wie sie beim Stand der Technik vorhanden sind zu verzichten, wodurch sich ein wesentlich einfacherer Aufbau ergibt. Außerdem werden durch die Speicherung der zuletzt eingestellten Werte allfällige, durch das Steuersignal bedingte Schwankungen vermieden, die einen wesentlichen Nachteil der bekannten Lösung darstellen. Weiters ergibt sich bei der erfindungsgemäßen Lösung auch ein wesentlich geringerer Stromverbrauch als bei den erwähnten Lösungen.

Fernbedienungen mit Hochfrequenz, Infrarot oder Ultraschall sind heute bei vielen Fernseh-Geräten, HiFi Anlagen usw. für eine Vielzahl von Funktionen, wie Kanalwahl, Lautstärke, Helligkeit, Farbsättigung u. dgl. üblich. Die dafür eingeführte Technologie ist jedoch für Hörgeräte nicht brauchbar, da die dafür angebotenen Schaltungen für Hörgeräte viel zu kompliziert und zu umfangreich sind. So muß bei diesen Fernbedienungsschaltungen im zu steuernden Gerät ein eigener Empfangsteil für den Empfang der Signale des Senders der Fernbedienung vorgesehen sein, wogegen, dies bei der Erfindung vermieden ist.

Beispielsweise wurde durch die DE-A-24 07 726 die Verwendung von Ultraschallsignalen zur Fernbedienung von mehreren Sendern von Drahtlosmikrofonen zum Zweck der Vermeidung von gegenseitigen Störungen, wenn nur eine geringe Anzahl von HF-Übertragungskanälen als Sender zur Verfügung stehen, wobei ein vorhandenes Mikrofon gleichzeitig als Empfänger für die Steuersignale dient. Im bekannten Fall handelt es sich jedoch um relativ große HiFi Mikrofone an einer sich über einen großen Raum verteilt angeordneten Mikrofonanlage, bei der sich wesentlich andere Probleme als bei einem Hörgerät ergeben.

Der Sender ist vorzugsweise derart ausgebildet, daß er einen mit einem Schallgeber in Verbindung stehenden Oszillator aufweist, wodurch sich ein sehr einfacher Aufbau ergibt.

Dabei ist es vorteilhaft, wenn der Oszillator über einen, von einem über einen Taster aktivierbaren Taktgenerator gesteuerten, in seinem nicht angesteuerten Zustand durchgeschalteten Schalter mit dem Lautsprecher verbunden ist. Damit läßt sich auf sehr einfache Weise eine Steuerung z. B. der Lautstärke mittels einfach zu bedienender Tasten, die auf den Sender einwirken, erreichen. So kann z. B. ein Dauersignal der Senders die Lautstärkeeinstellung des eigentlichen Hörgerätes im Sinne von lauter und ein durch den aktivierten Taktgenerator impulsmoduliertes Signal des Senders im Sinne von leiser beeinflussen.

Eine weitere Möglichkeit besteht auch darin, daß der Oszillator auf zwei verschiedene Frequenzen umschaltbar ist oder daß der Oszillator über einen Frequenz- oder Amplitudenmodulator mit dem Schallgeber verbunden ist, deren Modulationsgrad vorzugsweise in zwei Stufen veränderbar ist. In beiden Fällen kann die auf diese Weise übertragene Information durch einen, einer frequenzselektiven Schaltung nachgeschalteten Demodulator wiedergewonnen werden und z. B. der Lautstärkeeinstellung zugeführt werden.

Grundsätzlich kann aber zur Dekodierung der im Empfänger eintreffenden Steuersignale auch jede andere Art von Demodulatorschaltung verwendet werden, wie z. B. ein Digitalfilter oder ein Zähldiskriminator.

Für die Auswertung der Steuersignale, insbesondere wenn diese als Dauersignale und impulsmodulierte Signale anfallen, ist es vorteilhaft, wenn der frequenzselektiven Schaltung ein Hüllkurvendetektor nachgeschaltet ist, der mit einem Taktgenerator verbunden ist. Damit ergibt sich eine sehr einfache Auswerteschaltung, die getrennte Steuerimpulse z. B. für lauter und leiser liefert.

In diesem Zusammenhang kann weiters vorgesehen sein, daß der Hüllkurvendetektor einen Zähler steuert, der in Abhängigkeit von den Ausgangssignalen des Hüllkurvendetektors aufwärts- oder abwärts zählt und der in Abhängigkeit von seinem Zählerstand ein die Lautstärkeeinstellung beeinflussendes Netzwerk steuert. Dies ermöglicht es z. B. mit einem 4 bit Zähler eine Lautstärkenregelung in 15 Schritten aufzubauen, wobei mit einem entsprechend abgestimmten Netzwerk ein Regelumfang von z. B. 45 dB in 3 dB Schritten erzielt werden kann.

Nach einem weiteren Merkmal der Erfindung ist vorgesehen, daß der Speicher als digitale Schaltung, vorzugsweise als Zähler ausgebildet ist, die gegebenenfalls in MOSTechnik ausgeführt und ständig mit der Batterie verbunden ist. Damit wird auf sehr einfache Weise erreicht, daß die einmal gewählte Einstellung der Lautstärke erhalten bleibt und die Schaltung nicht ständig mit Steuersignalen beaufschlagt werden muß und diese Einstellung auch nach Abschalten und Wiederinbetriebnahme des Hörgerätes erhalten bleibt.

Besonders zweckmäßig ist es, wenn der Speicher als nicht flüchtiger digitaler Speicher z. B. als EEPROM oder « non volatile » RAM ausgebildet ist, da auf diese Weise auf eine Stützung des Speichers durch die Batterie verzichtet werden kann.

Grundsätzlich ist es aber auch möglich, den Speicher für die Lautstärkeinformation als analoge Schaltung auszubilden, z. B. mit einem Kondensator als Speicherelement und einem Feldeffekttransistor als gesteuerten Widerstand.

Die Erfindung wird nun an Hand der Zeichnung näher erläutert. Dabei zeigt :

Figur 1 schematisch ein Ausführungsbeispiel eines Senders für die Fernbedienung ;

Figur 1a und 1b mit diesem Sender erzielbare Signalzüge ;

Figur 2 schematisch ein erfindungsgemäßes Hörgerät mit Fernbedienung ;

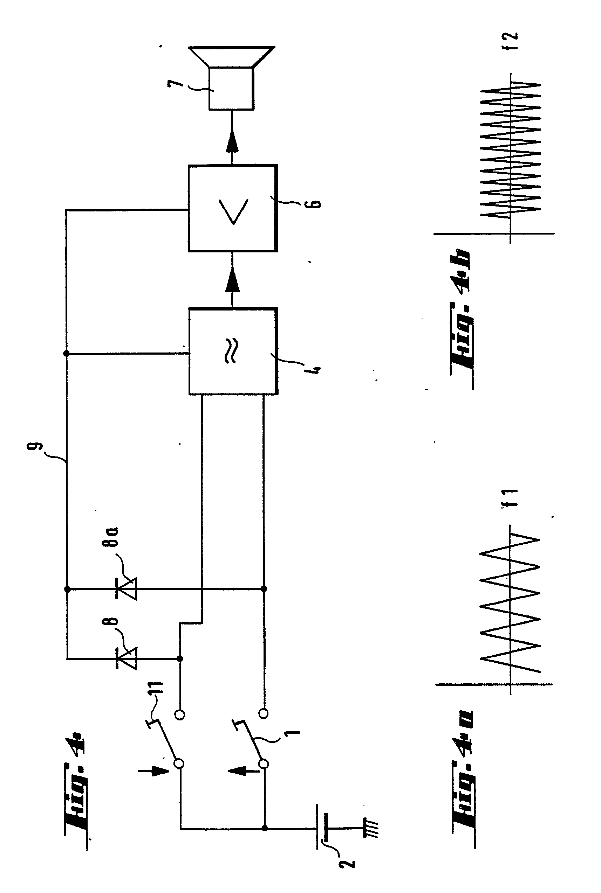

die Figur 3a und 3b Signalzüge einer gegenüber dem Sender gemäß Figur 1 abgewandelten Ausführungsform eines Senders ;

Figur 4 ein Ausführungsbeispiel eines Senders mit zwei Frequenzen ;

Figur 5 ein Ausführungsbeispiel eines Senders mit umschaltbarer Modulation ;

Figur 6 ein Ausführungsbeispiel eines Hörgerätes mit digitalen Filtern zur Signalerkennung ;

Figur 7 ein Ausführungsbeispiel mit digitalem Speicher für die eingestellte Lautstärkeinformation ; und

Figur 8 ein Ausführungsbeispiel für eine analoge Schaltung des Empfängerteiles des Hörgerätes.

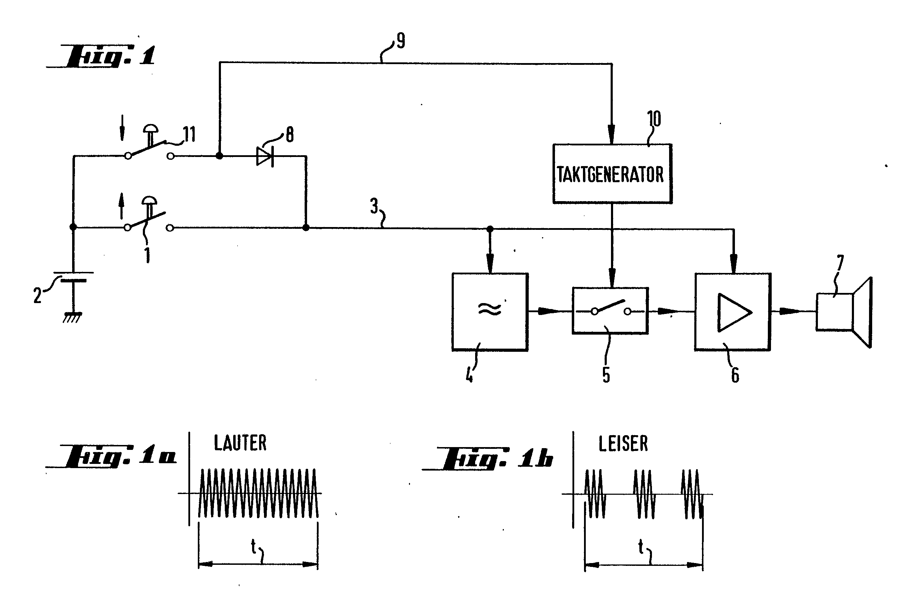

Figur 1 zeigt ein Blockschaltbild des Senders. Bei Druck auf die Taste 1 gelangt die Spannung der Stromquelle 2 über eine Versorgungsleitung 3 auf einen Oszillator 4, der eine Schwingung passender Frequenz erzeugt. Die Ausgangsspannung der Oszillators 4 wird über einen Schalter 5, der normalerweise geschlossen ist, an die Endverstärkerstufe 6 geführt, die ihre Ausgangsleitung an einen Schallgeber 7 abgibt, der nun seinerseits das erzeugte Signal an die umgebende Luft als Schallwellen abstrahlt. Das Signal wird mit konstanter Amplitude solange abgestrahlt als die Taste 1 gedrückt ist. Die Sperrdiode 8 verhindert, daß die Versorgungsspannung von der Leitung 3 auch auf die Versorgungsleitung 9 gelangt und den Taktgeber 10 in Betrieb setzt.

Figur 1a zeigt schematisch den Signalverlauf während der Zeit t, in der die Taste 1 gedrückt ist. Dieses Signal wird, wie noch erläutert werden wird, von der Lautstärkenregelung des Hörgerätes beispielsweise als Information « lauter » erkannt.

Wird hingegen die Taste 11 gedrückt, so gelangt die Versorgungsspannung nicht nur über die jetzt leitende Diode 8 und die Leitung 3 an den Oszillator 4 und den Endverstärker, sondern gleichzeitig über Leitung 9 auch an den Taktgenerator 10, der seinerseits den Schalter 5 ansteuert und periodisch öffnet und schließt.

Durch das Öffnen und Schließen des Schalters 5 wird vom Schallgeber 7 jetzt ein gepulstes Signal abgestrahlt, solange die Taste 11 gedrückt wird, wir Figur 1b zeigt. Das gepulste Signal wird beispielsweise als Information « leiser » erkannt.

Die beschriebene Ausführung des Senders mit den diskreten Blöcken 4, 5 und 10 ist nur eine denkbare Form. Eine andere denkbare Lösung zur Erzeugung eines gepulsten Signals nach Figur 1b wäre z. B. der Ersatz des Taktgenerators 10 durch eine Zählerschaltung, die den Oszillator 4 nach einer bestimmten Anzahl von Schwingungen für einige Zeit stoppt und ihn dann wieder freigibt, worauf sich das Spiel wiederholt. Je nach dem ob Taste 1 oder 11 gedrückt ist, ist der Zähler in Betrieb oder nicht und der Sender liefert ein Signal nach Figur 1a oder Figur 1b. Geeignete I.C., die Oszillator und Zähler enthalten gibt es bereits oder sind in Vorbereitung. Der Sender würde dadurch besonders einfach.

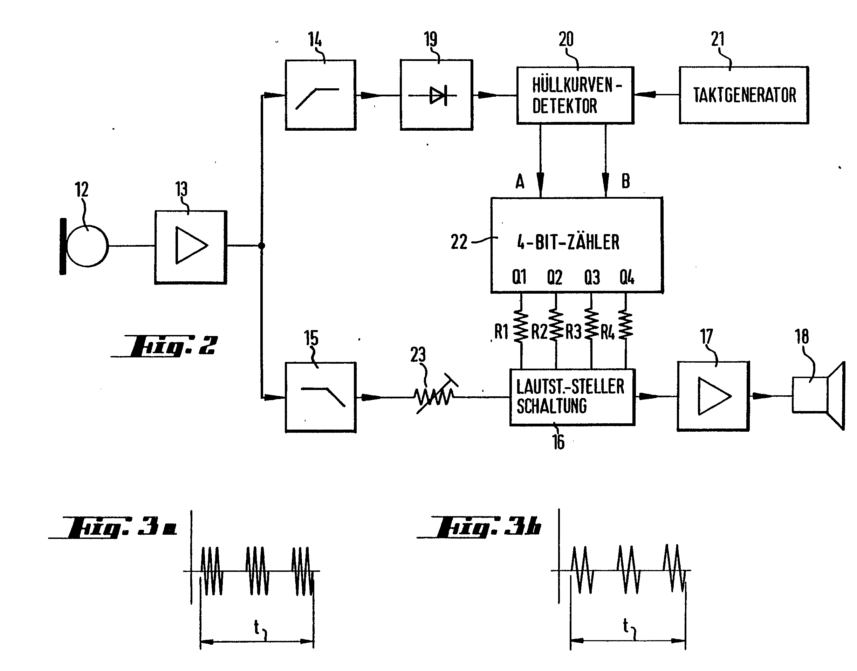

Figur 2 zeigt ein Blockschaltbild des zugehörigen Hörgerätes mit integriertem Empfänger für die Lautstärke-Ferneinstellung. Das Mikrofon 12 nimmt sowohl Umweltgeräusche (Sprache) als auch das vom Sender gelieferte Steuer-Schallsignal auf, dessen Frequenz zweckmäßigerweise außerhalb des Übertragungsbereiches des Hörers 18 des Hörgerätes liegt. In einem Vorverstärker 13 wird das Signalgemisch zunächst verstärkt und anschließend über einen Hochpaß 14 und einen Tiefpaß 15 getrennt. Das Sprachsignal gelangt vom Tiefpaß 15 über die Lautstärke-Regelungsschaltung 16 an eine Endstufe 17 und schließlich an den Hörer 18. Der Hörgeräteteil 16, 17, 18 ist in bekannter Art ausgeführt und bietet keine Besonderheiten. Weitere Einstellmöglichkeiten zur Begrenzung des Ausgangsschalldrucks oder zur Tonbeeinflußung sind möglich aber nicht dargestellt.

Das Steuer-Schallsignal gelangt über den Hochpaß 14 an einen Gleichrichter 19, der an seinem Ausgang — je nach dem ob Taste 1 oder 11 im Sender gedrückt sind — eine kontinuierliche oder gepulste Gleichspannung an der Hüllkurvendetektor 20 abgibt. Der Hüllkurvendetektor arbeitet mit einem Taktgenerator 21 zusammen, für den sich eine Taktrate von 0,3-1 sec als vorteilhaft erwiesen hat. Der Hüllkurvendetektor erkennt, ob ein kontinuierliches oder ein gepulstes Eingangs-Signal vorhanden ist und liefert demtentsprechend über die Leitungen A oder B Impulse an einen 4-bit-Zähler 22. Je nach dem, ob die Impulse über A oder B kommen, zählt der Zähler 22 die einlangenden Impulse hinauf oder hinunter und erzeugt an seinen Ausgängen Q1 ... Q4 entsprechendes bit-Muster. Die Ausgänge sind ihrerseits mit vier Widerständen R1 ... R4 beschaltet. Die Widerstände sind so gewählt, daß sie zusammen mit einer bekannten und nicht weiter dargestellten Lautstärkesteller-Schaltung 16 die Verstärkung im Hörgerätsignalzung um -3dB/-6dB/-12dB/-24dB beeinflussen. Je nach dem am Zählerausgang anliegenden bit-Muster kann jeder Widerstand allein oder in Kombination mit anderen eingeschaltet werden, sodaß sich ein gesamter Regelumfang von 45dB in 3dB-Schritten ergibt. Sollte dieser Regelumfang (z. B. bei sehr hochverstärkenden Geräten) nicht ausreichen, so kann noch ein zusätzlicher Trimmwiderstand 23 vorgesehen sein, mit dem das Gerät einmalig bei der Anpassung an den individuellen Hörverlust des Schwerhörigen eingestellt werden kann. Dieser Trimmwiderstand 23 ist jedoch für den Träger des Hörgerätes nicht ohne weiteres zugänglich.

Wird der Zähler, der gleichzeitig als Speicher für die Lautstärke-Information dient, in C-MOS Ausführung aufgebaut, so ist es ohne Schwierigkeiten und mit minimalstem Stromverbrauch möglich, den « Zählerstand » auch dann zu erhalten, wenn das Hörgerät ausgeschaltet ist. Nach dem Wieder-Einschalten spielt das Gerät dann in der vorher eingestellten Lautstärke. Es wäre aber auch möglich, den Speicher für die Lautstärke-Information durch ein EEPROM oder « non volatile » RAM zu bilden, wodurch sich eine Stützung des Speichers durch die Batterie erübrigt. Grundsätzlich kann der Speicher aber auch analog ausgebildet sein, z. B. mittels eines Kondensators als Speicherelement und mit einem Feldeffekttransistor, wobei der Feldeffekttransistor als gesteuerter Widerstand arbeitet.

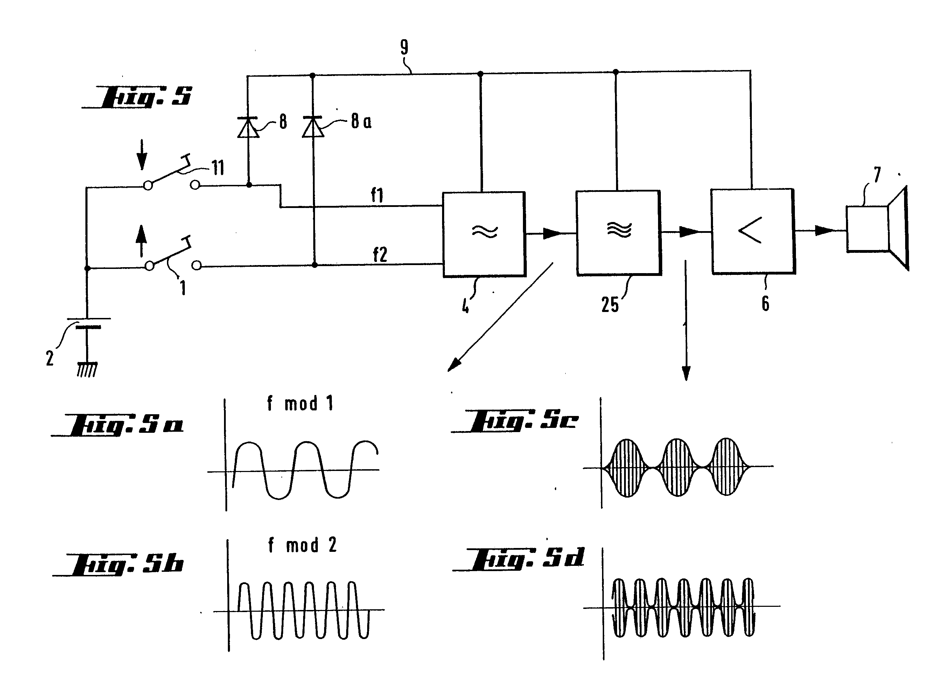

Figur 4 zeigt eine Schaltung für einen Sender, der auf zwei Frequenzen umschaltbar ist. Bei Druck auf die Taste 1 gelangt die Spannung der Stromquelle 2 über die Diode 8a an die Versorgungsleitung 9, wodurch der Oszillator 4 und die Endstufe 6 mit Strom versorgt werden. Die Endstufe gibt ihre Ausgangsleistung wieder an den Schallgeber 7 ab.

Der Oszillator 4 kann z. B. ein spannungsgesteuerter Oszillator (VCO) mit zwei Steuereingängen f1 und f2 sein. Je nachdem, welcher Eingang aktiviert ist, schwingt der Oszillator auf einer tiefen Frequenz f1 (Figur 4a) oder einer hohen Frequenz f2 (Figur 4b). Bei Druck auf Taste 1 wird f2 aktiviert. Die Diode 8 verhindert einen Stromfluß an f1. Bei Druck auf die Taste 11 wird f1 aktiviert und die Versorgungsleitung über Diode 8 gespeist. Die Diode 8a verhindert eine Aktivierung von f2.

Im eigentlichen Hörgerät (Figur 2) würde der Gleichrichter 19 und der Taktgenerator 21 entfallen und der Hüllkurvendetektor 20 wäre durch einen PLL-Tone-Dekoder zu ersetzen. Es ist dies nach dem phase-locked-loop Prinzip arbeitender frequenzselektiver Baustein, dessen Funktion allgemein bekannt ist. Ein typischer Vertreter solcher Bausteine wäre z. B. die Type NE 567 (Signetic, Exar). Nähere Einzelheiten je nach den bereits getaktet eintreffenden Signalen unterschiedlicher Frequenz liefert der PLL-Tone-Dekoder entsprechende Impulse an die Leitungen A und B, wodurch der 4-bit-Zähler die Verstärkung der Hörgeräteschaltung in der vorher beschriebenen Weise verändert.

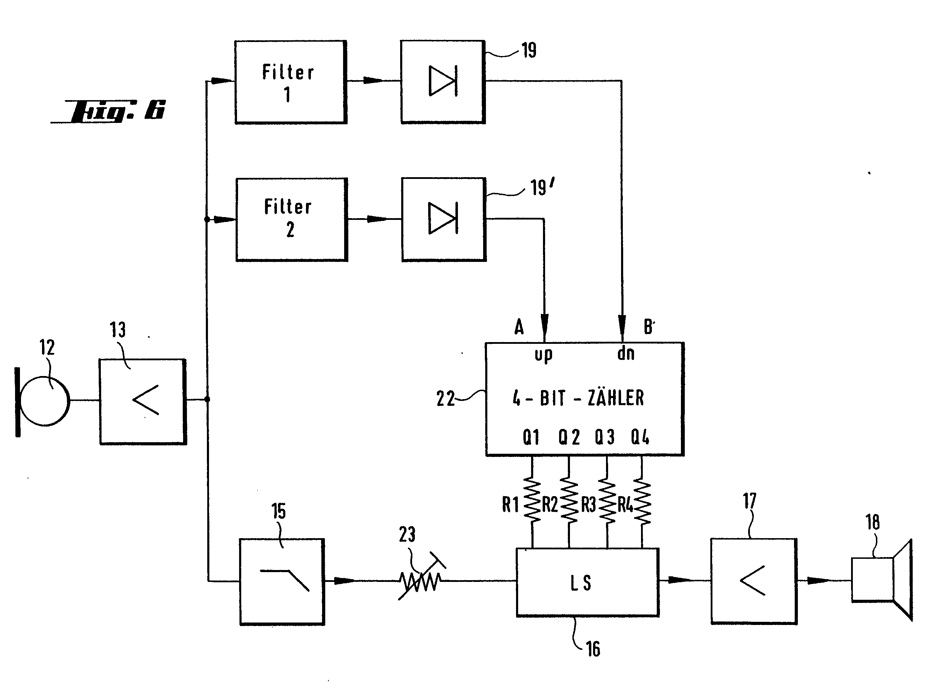

Figur 5 ist eine Schaltung für einen Sender mit umschaltbarer Modulation, hier z. B. mit Amplitudenmodulation. Die Schaltung ist im wesentlichen identisch mit Figur 4 und es werden die gleichen Bezugsziffern verwendet. Die vom Oszillator 4 gelieferten Modulationsfrequenzen fmod 1 und fmod 2 gelangen jedoch jetzt nicht direkt an die Endstufe 6, sondern modulieren einen Trägerfrequenz-Oszillator 25, der eine über fmod 1 und fmod 2 liegende Frequenz erzeugt. Am Ausgang des Oszillators 25 bzw. am Eingang der Endstufe 6 steht jetzt ein moduliertes Trägerfrequenzsignal zur Aussendung durch den Schallgeber 7 zu Verfügung. Figur 5a zeigt schematisch die tiefe Modulationsfrequenz fmod 1. Figur 5c den damit modulierten Träger; Figur 5b und 5d dementsprechend mit hoher Modulationsfrequenz fmod 2. Als Beispiel ist hier ein amplitudenmodulierter Sender beschrieben. Das gleiche Prinzip ist natürlich auch für Frequenz- oder Impulsmodulation denkbar.

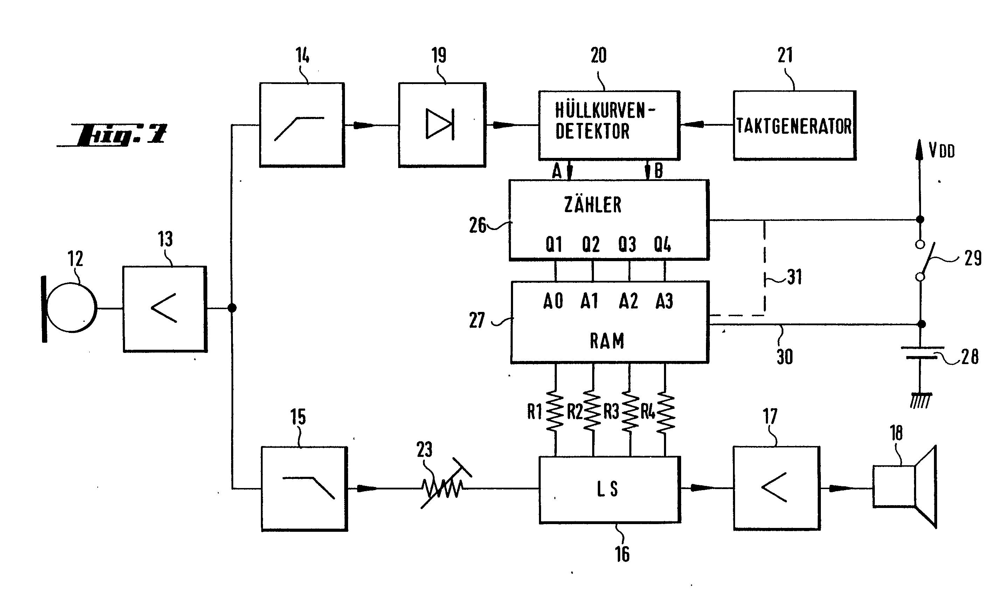

Figur 6 zeigt schematisch ein erfindungsgemäßes Hörgerät mit digitalen Filtern zur Signalerkennung. Nach dem Vorverstärker 13 im Empfänger teilt sich das Signal. Die « Informationskomponente » speist über eine frequenzselektive Schaltung (Tiefpaß 15) den eigentlichen Hörgeräteteil, wie zu Figur 2 beschrieben. Die « Steuerkomponente » gelangt an zwei digitale Filter (Filter 1/Filter 2). Die Filter erkennen die angebotene Informationsart (« leiser, lauter ») und liefern über die Gleichrichter 19, 19' die entsprechenden Steuerspanungen A oder B für den Zähler 22. Da die beiden Filter in sich frequenzselektiv sind, entfällt hier der Hochpaß 14 aus Figur 2.

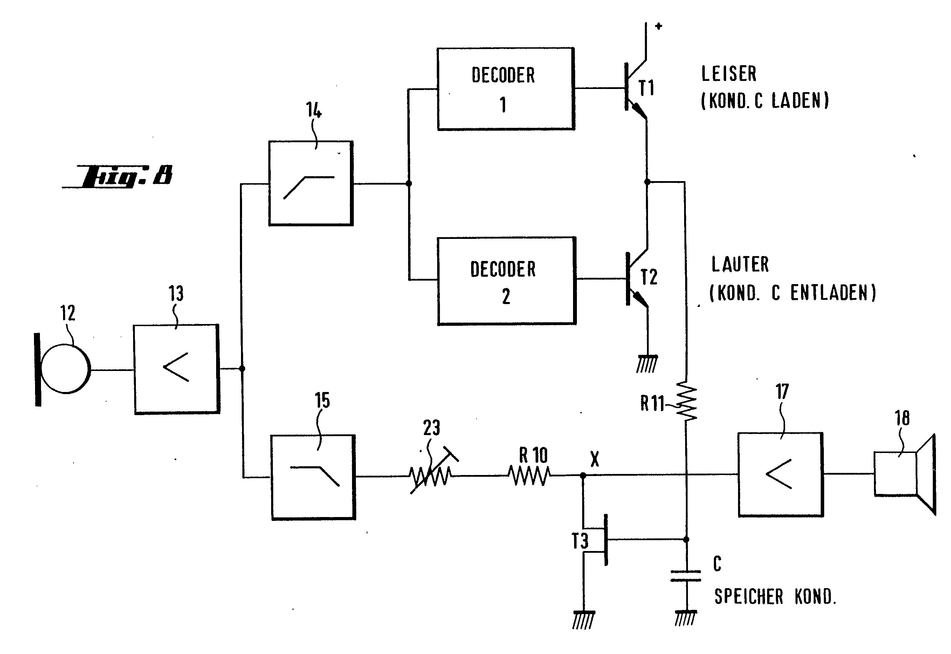

Figur 7 zeigt ein Ausführungsbeispiel eines Hörgerätes mit getrenntem, digitalem Speicher für die eingestellte Lautstärkeinformation. Die Gewinnung der Lautstärkeinformation A/B geschieht wie zu Figur 2 beschrieben. Signale A oder B bewirken wieder, daß der Zähler 26 hinauf oder hinunter zählt. Der Zählerstand wird als 4-bit Information in den Speicher 27 eingelesen, der sie festhält und über die Widerstande R1 ... R4 und die Lautstärkesteller-Schaltung 16 die Verstärkung des Hörgerätes beeinflußt. Die Stromversorgung des Empfängers erfolgt aus der Stromquelle 28, die über einen Ein/Aus-Schalter 29 an den Zähler 26 und die übrigen Bausteine der Schaltung (Anschluß $V_{DD}$) angeschlossen ist. Handelt es sich beim Speicher 27 um ein « normales » C-MOS-RAM, so wird dieses über Leitung 30 ständig aus der Batterie mit Strom versorgt, handelt es sich hingegen um ein EEPROM (« non volatile RAM »), so kann dieses über die gestrichelte Leitung 31 mit der geschalteten Stromversorgung verbunden sein, da es in den Betriebspausen keine Spannung zur Erhaltung des Speicherinhaltes benötigt.

Figur 8 zeigt ein Ausführungsbeispiel für eine analoge Schaltung des Empfängerteiles des Hörgerätes. Im Empfänger ist wieder ein Mikrofon 12 und ein Vorverstärker 13 vorhanden, nach dem sich der Signalweg teilt. Die Informationskomponente gelangt über den Tiefpaß 15 und einen Trimmer zur Grobeinstellung der Lautstärke 23 an einen gesteuerten Spannungsteiler, der aus einem Längswiderstand R10 und dem als gesteuerten Querwiderstand arbeitenden Feldeffekttransistor T3 besteht. Die am Abgriff des Spannungsteilers (Punkt X) stehende NF-Spannung wird normal in Endstufe 17 und Hörer weiterverarbeitet.

Die Steuerkomponente gelangt wieder über den Hochpaß 14 an zwei Dekoder 1, 2, die das vom Sender kommende Steuersignal erkennen, dekodieren und an ihrem Ausgang mit einem entsprechenden Signal beantworten. Ist der Ausgang des Dekoders 1 « high », so wird der Transistor T1 leitend und lädt über den Widerstand R11 den Speicherkondensator C. Durch die steigende Spannung an C wird auch der Gate-Anschluß von T3 positiver und T3 wird leitend. Damit wird die am Punkt X stehende NF-Spannung kleiner « leiser ». Wird der Ausgang von Dekoder 1 « low » und der Ausgang von Dekoder 2 « high », so wird Transistor T2 leitend und Kondensator C entlädt sich über T2. Die sinkende Spannung an Kondensator C und dem Gate-Anschluß von T3 macht diesen hochohmig, wodurch die NF-Signalspannung am Punkt X größer wird (« lauter »). Liegt keine Steuerinformation vor, so sind beide Dekoder-Ausgänge « low » und R1 und T2 gesperrt. Die Ladung an Kondensator C kann sich nicht verändern. Damit hat auch T3 einen konstanten Widerstand und die eingestellte Lautstärke ändert sich nicht.

**Patentansprüche**

1. Hörgerät mit einer Fernsteuereinrichtung zur Lautstärkesteuerung, wobei das Hörgerät ein Mikrofon, eine Verstärkerschaltung, eine Lautstärkesteurschaltung und einen Hörer aufweist und die Fernsteuereinrichtung einen vom Hörgerät räumlich getrennten und diesem individuell zugeordneten Sender aufweist, der die Lautstärkesteuerschaltung beeinflussende Steuersignale wahlweise abstrahlt, und im Hörgerät eine Empfangseinrichtung für diese Steuersignale vorgesehen ist, der die Lautstärkesteuerschaltung nachgeschaltet ist, dadurch gekennzeichnet, daß der Sender zur Abstrahlung von im Übertragungsbereich des Mikrofons (12) des Hörgerätes und außerhalb des Übertragungsbereiches dessen Hörers (18) liegenden Steuersignale vorgesehen ist und das Mikrofon (12) gleichzeitig die Empfangseinrichtung für die Steuersignale bildet, wobei dem Mikrofon (12) eine durch ein Hoch- und ein Tiefpaßfilter (14, 15) gebildete frequenzselektive Schaltung zur Trennung der Nutz- von den Steuersignalen nachgeschaltet ist und die der frequenzselektiven Schaltung (14, 15) nachgeschaltete Lautstärkesteuerschaltung einen Speicher zur Speicherung der der eingestellten Lautstärke entsprechenden Signale aufweist.

2. Hörgerät nach Anspruch 1, dadurch gekennzeichnet, daß der Sender einen mit einem Schallgeber (7) in Verbindung stehenden Oszillator (4) aufweist.

3. Hörgerät nach Anspruch 2, dadurch gekennzeichnet, daß der Oszillator (4) über einen, von einem über einen Taster (11) aktivierbaren Taktgenerator (10) gesteuerten, in seinem nicht angesteuerten Zustand durchgeschalteten Schalter (5) mit dem Schallgeber (7) verbunden ist.

4. Hörgerät nach Anspruch 2, dadurch gekennzeichnet, daß der Oszillator (4) auf zwei verschiedene Frequenzen umschaltbar ist (4, Figur 4).

5. Hörgerät nach Anspruch 2, dadurch gekennzeichnet, daß der Frequenzimpuls oder amplitudenmodulierbare Oszillator (4) mit dem Schallgeber (7) verbunden ist, dessen Molulationsgrad vorzugsweise in zwei Stufen veränderbar ist (4, 7, Figur 5).

6. Hörgerät nach einem der Ansprüche 1 bis 5, dadurch gekennzeichnet, daß der frequenzselektiven Schaltung (14, 15) ein Hüllkurvendetektor (20) nachgeschaltet ist, der mit einem Taktgebergenerator (21) verbunden ist.

7. Hörgerät nach Anspruch 5, dadurch gekennzeichnet, daß der Hüllkurvendetektor (20) einen Zähler (22) steuert, der in Abhängigkeit von den Ausgangssignalen des Hüllkurvendetektors (20) aufwärts- oder abwärts zählt und der in Abhängigkeit von seinem Zählerstand ein die Lautstärkeeinstellung (16) beeinflussendes Netzwerk (R1 ... R4) steuert.

8. Hörgerät nach einem der Ansprüche 1 bis 5, dadurch gekennzeichnet, daß der frequenzselektiven Schaltung ein die Lautstärkeeinstellung steuerndes Digitalfilter zur Dekodierung der vom Sender kommenden Signale nachgeschaltet ist.

9. Hörgerät nach einem der Ansprüche 1 bis 5, dadurch gekennzeichnet, daß der frequenzselektiven Schaltung ein die Lautstärkeeinstellung steuernder Zähldiskriminator zur Dekodierung der vom Sender kommenden Signale nachgeschaltet ist.

10. Hörgerät nach Anspruch 1, dadurch gekennzeichnet, daß der Speicher als digitale Schaltung, vorzugsweise als Zähler (22) ausgebildet ist, die gegebenenfalls in MOS-Technik ausgeführt und ständig mit der Batterie verbunden ist (22, Figur 7).

11. Hörgerät nach Anspruch 1, dadurch gekennzeichnet, daß der Speicher als nicht flüchtiger digitaler Speicher, z. B. als EEPROM oder « non volatile » RAM ausgebildet ist.

12. Hörgerät nach Anspruch 1, dadurch gekennzeichnet, daß der Speicher als analoge Schaltung ausgebildet ist.

**Claims**

1. Hearing aid with a remote-control device for controlling the volume, the hearing aid having a microphone, an amplification circuit, a volume control circuit and an earphone and the remote-control device has a transmitter, spatially separated from the hearing aid and individually allocated to it, said transmitter selectively emitting control signals influencing the volume control circuit, and a receiving device being provided in the hearing aid for these control signals with the volume control circuit connected after it, characterised in that the transmitter is provided for emitting control signals lying within the transmission range of the microphone (12) of the hearing aid and outside the transmission range of its earphone (18), and the microphone (12) forms, at the same time, the receiving device for the control signals, a frequency-selective circuit, formed by a high-pass and a low-pass filter (14, 15), for separating the useful signals from the control signals, being connected after the microphone (12), and the volume control circuit, connected after the frequency-selective circuit (14, 15), has a memory for storing the signals corresponding to the volume set.

2. Hearing aid according to claim 1, characterised in that the transmitter has an oscillator (4) connected to a sound generator (7).

3. Hearing aid according to claim 2, characterised in that the oscillator (4) is connected to the sound generator (7) by way of a switch (5) controlled by a clock generator (10) activated by a key device (11) and being closed when not subjected to a control signal.

4. Hearing aid according to claim 2, characterised in that the oscillator (4) is switchable between two different frequencies (4, figure 4).

5. Hearing aid according to claim 2, characterised in that the frequency pulse or the amplitude-modulated oscillator (4) is connected to the sound generator (7), the modulation factor of which is preferably able to be altered in two stages (4, 7, figure 5).

6. Hearing aid according to one of claims 1 to 5, characterised in that an envelope curve detector (20), which is connected to a clock generator (21), is connected after the frequency-selective circuit (14, 15).

7. Hearing air according to claim 5 (sic), characterised in that the envelope curve detector (20) controls a counter (22) which, depending on the output signals of the envelope curve detector (20), counts upwards and downwards and which controls a network (R1 ... R4) affecting the volume setting (16) in dependence on its counter state.

8. Hearing aid according to one of claims 1 to 5, characterised in that a digital filter controlling the volume setting is connected after the frequency-selective circuit for decoding the signals coming from the transmitter.

9. Hearing air according to one of claims 1 to 5, characterised in that a counter discriminator, controlling the volume setting is connected after the frequency-selective circuit for decoding the signals coming from the transmitter.

10. Hearing aid according to claim 1, characterised in that the memory is constructed as a digital circuit, preferably as a counter (22), which may be constructed using MOS technology and is continuously connected to the battery (22, figure 7).

11. Hearing aid according to claims 1, characterised in that the memory is constructed as a non-volatile digital memory, e. g. as EEPROM or non-volatile RAM.

12. Hearing aid according to claim 1, characterised in that the memory is constructed as an analog circuit.

## Revendications

1. Aide auditive comportant un dispositif de commande à distance pour le réglage de la puissance sonore, l'aide auditive présentant un microphone, un circuit d'amplification, un circuit de réglage de la puissance sonore ou circuit de réglage de volume et un écouteur, et le dispositif de commande à distance présentant un émetteur séparé dans l'espace de l'aide auditive et coordonné individuellement à celle-ci, qui rayonne, sélectivement, des signaux de commande agissant sur le circuit de réglage de volume, l'aide auditive étant équipée d'un dispositif de réception pour ces signaux de commande, dispositif qui est suivi du circuit de réglage de volume, caractérisée en ce que l'émetteur est conçu pour rayonner des signaux de commande se trouvant dans le domaine de transmission du microphone (12) de l'aide auditive et en dehors du domaine de transmission de son écouteur (18) et que le microphone (12) constitue en même temps le dispositif de réception pour les signaux de commande, le microphone (12) étant suivi d'un circuit sélectif en fréquence, formé d'un filtre passe-haut et d'un filtre passe-bas (14, 15) pour séparer les signaux utiles des signaux de commande et le circuit de réglage de volume, prévu à la suite du circuit sélectif en fréquence (14, 15), présentant une mémoire pour la mémorisation des signaux correspondants à la puissance sonore ajustée.

2. Aide auditive selon la revendication 1, caractérisée en ce que l'émetteur présente un oscillateur (4) qui est en liaison avec un générateur de son (7).

3. Aide auditive selon la revendication 2, caractérisée en ce que l'oscillateur (4) est relié au générateur de son (7) à travers un interrupteur (5) qui est commandé par une horloge (10), pouvant être activée par un bouton-pressoir (11) et qui est fermé dans son état non commandé.

4. Aide auditive selon la revendication 2, caractérisée en ce que l'oscillateur (4) est commutable sur deux fréquences différentes (4, figure 4).

5. Aide auditive selon la revendication 2, caractérisée en ce que l'oscillateur (4), pouvant être modulé en fréquence, par impulsion, ou en amplitude, est relié à un générateur de son (7) dont le taux de modulation est variable, de préférence à deux niveaux (4, 7, figure 5).

6. Aide auditive selon une des revendications 1 à 5, caractérisée en ce que le circuit sélectif en fréquence (14, 15) est suivi d'un détecteur d'enveloppante (20) qui est relié à une horloge (21).

7. Aide auditive selon la revendication 5, caractérisée en ce que le détecteur d'enveloppante (20) commande un compteur (22) qui, en fonction des signaux de sortie du détecteur d'enveloppante (20), effectue un comptage progressif ou régressif et commande, en fonction de sa position, un réseau (R1 ... R4) agissant sur le réglage de volume (16).

8. Aide auditive selon une des revendications 1 à 5, caractérisée en ce que le circuit sélectif en fréquence est suivi, en vue du décodage des signaux venant de l'émetteur, d'un filtre numérique commandant le réglage de volume.

9. Aide auditive selon une des revendications 1 à 5, caractérisée en ce que le circuit sélectif en fréquence est suivi, en vue du décodage des signaux venant de l'émetteur, d'un discriminateur-compteur commandant le réglage de volume.

10. Aide auditive selon la revendication 1, caractérisée en ce que la mémoire est constituée par un circuit numérique, formant de préférence un compteur (22), qui est réalisé éventuellement en technologie (MOS) et est relié en permanence à la batterie ou la pile (22 figure 7).

11. Aide auditive selon la revendication 1, caractérisée en ce que la mémoire est réalisée comme une mémoire numérique non volatile, par exemple comme une EEPROM ou RAM « non volatile ».

12. Aide auditive selon la revendication 1, caractérisée en ce que la mémoire est réalisée sous la forme d'un circuit analogique.

**Fig. 1**

TAKTGENERATOR

**Fig. 1a** | LAUTER

t

**Fig. 1b** | LEISER

t

EP 0 168 895 B1

**Fig. 2**

14

15

19

20 HÜLLKURVEN-DETEKTOR

21 TAKTGENERATOR

12

13

A B

22 4-BIT-ZÄHLER

Q1 Q2 Q3 Q4

R1 R2 R3 R4

23

16 LAUTST.-STELLER SCHALTUNG

17

18

**Fig. 3a**

$t_1$

**Fig. 3b**

$t_1$

EP 0 168 895 B1

**Fig. 4**

8    8a

11

9

≈    <    7

1

2

4    6

**Fig. 4a**    f1

**Fig. 4b**    f2

Fig. 5

Fig. 5a

Fig. 5b

Fig. 5c

Fig. 5d

f mod 1

f mod 2

f1

f2

8a

8

11

1

2

9

4

25

6

7

4

EP 0 168 895 B1

Fig. 6

**Fig. 1**

HÜLLKURVEN-DETEKTOR (20)

TAKTGENERATOR (21)

ZÄHLER (26)

A    B

Q1  Q2  Q3  Q4

A0  A1  A2  A3

RAM (27)

R1  R2  R3  R4

L S (16)

$V_{DD}$

EP 0 168 895 B1

Fig. 8

DECODER 1

DECODER 2

T1  LEISER (KOND. C LADEN)

T2  LAUTER (KOND. C ENTLADEN)

+

14

13

12

15

23

R 10

X

R11

17

18

T3

C

SPEICHER KOND.

EP 0 168 895 B1